Europäisches Patentamt

**European Patent Office**

Office européen des brevets

(19)

(11) **EP 0 690 143 A1**

(12) **EUROPEAN PATENT APPLICATION**

(43) Date of publication:
03.01.1996 Bulletin 1996/01

(51) Int. Cl.$^6$: **C23C 2/08**

(21) Application number: 95303434.5

(22) Date of filing: 23.05.1995

(84) Designated Contracting States:
DE GB NL

(30) Priority: 27.06.1994 US 265867

(71) Applicant: **GENERAL ELECTRIC COMPANY**
Schenectady, NY 12345 (US)

(72) Inventors:
• **Benz, Mark Gilbert**
Burnt Hills, New York 12027 (US)
• **Johnson, Neil Anthony**
Schenectady, New York 12309 (US)

• **Murray, Melissa Lea**
Schagticoke, New York 12154 (US)
• **Zabala, Robert John**
Schenectady, New York 12303 (US)
• **Hibbs, Louis Emerson, Jr.**
Schenectady, New York 12309 (US)
• **Knudsen, Bruce Alan**
Amsterdam, New York 12010 (US)

(74) Representative: **Greenwood, John David et al**
London WC2R 3AA (GB)

(54) **Method of coating niobium foil**

(57) A method of coating niobium foil with tin is disclosed. The tin bath is made up of tin and up to about twenty weight percent copper. The bath is run between about 300-800°C. Prior to the tin coating, the foil is preheated in a substantially oxygen free atmosphere.

EP 0 690 143 A1

## Description

This invention relates to a method of coating niobium foil with tin by hot dipping.

As will be explained the invention provides a method for applying tin-copper coatings to wettable niobium-based alloy foils by substantially lowering the temperature of the molten tin alloy bath below the temperature that triniobium tin forms, thereby minimizing triniobium tin forms, thereby minimizing triniobium tin dross formation in the tin alloy bath.

The intermetallic compound triniobium tin, $Nb_3Sn$, is a type-II metallic superconductor of interest because it has high values of superconducting critical current density in high magnetic fields. Historically, $Nb_3Sn$ has been formed using a number of different processes. These include: 1) condensation from the vapor phase; 2) crystallization from the liquid phase; 3) diffusion between one solid phase and one liquid; and 4) diffusion between two solid phases.

One technique developed for forming $Nb_3Sn$ by liquid-solid diffusion is to react liquid tin with solid niobium. An integral step in this method is coating a niobium-based alloy substrate with a tin or tin-copper alloy by hot dipping.

Tin hot dipping proceeds by drawing niobium foil through a molten tin bath. The tin bath is positioned in a chamber containing an inert atmosphere, such as argon. A roller located in the bath transfers the foil through the molten tin, which is held at a temperature greater than 950°C. At this temperature, wetting of the tin to the niobium foil is promoted by either the short hot zone above the tin bath or in the tin bath itself. As the foil leaves the bath, a layer of tin coats the surface of the niobium foil. The coated foil then exits through an inert atmosphere which serves to cool and solidify the tin layer. In a subsequent reaction anneal, the triniobium tin superconductor is formed by the reaction of tin with the niobium.

In order to provide a sufficient amount of tin for the reaction anneal step, a minimum limit is imposed on the thickness of the tin coating provided by the tin dip. Generally, the thickness of the tin layer is about two to thirty micrometers thick. At a constant foil speed through the tin bath, the thickness of the coating is inversely proportional to the temperature of the bath.

Further, the minimum limit imposed on the thickness of the tin coating places a lower limit on the foil speed passing through the tin dip. Faster foil speeds increase the rate of heat production from the foil in the exit chamber. Thus, it is necessary to have a cooling system that can efficiently remove heat from the exiting foil and solidify the tin coating.

While the above described method is currently being used to coat niobium foils with tin, the method has drawbacks. For instance, the conventional 1050°C operating temperature of the tin dip promotes the formation of triniobium tin dross on the surface of the molten tin bath. As a result, when the niobium foil exits the bath, it passes through the dross and pulls some of the dross material onto the tin coating, thereby contaminating the tin layer.

Another drawback of the 1050°C tin dip is the exceedingly reactive nature of tin at this temperature. This is a drawback because it means that dross, triniobium tin and niobium-oxide compounds, is formed more rapidly. This can necessitate a short dwell time for the niobium foil in the bath. The short time means faster foil speeds in the bath, which in turn increases the heat production from the exiting foil. This puts higher demands on the cooling system for the exiting foil, and further poses a safety issue.

There is a need to have a tin dip process that substantially minimizes triniobium tin dross formation, accommodates slower foil speeds to reduce the demands on the cooling system, and wets the niobium foil.

This invention fulfills these needs by providing an improved tin dip process that comprises preheating a niobium substrate (for example a foil) in a substantially oxygen free atmosphere to form a substantially oxide-free surface and then dipping the niobium substrate in a substantially oxygen free atmosphere in a tin bath at about 300-800°C, thereby minimizing triniobium tin dross formation in the bath. A substantially oxide-free surface means that if a minimal oxide coating is present on the surface of the niobium substrate prior to tin dipping, its presence does not interfere with the wetting of the tin coating to the niobium surface.

The preheating of the niobium substrate and the tin bath are done in a closed chamber which contains a substantially oxygen free atmosphere, such as an inert atmosphere comprised of argon gas. A substantially oxygen free atmosphere can have up to twenty parts per million oxygen present without effecting the preheat and subsequent tin dip steps of this method.

A niobium substrate includes articles comprising pure niobium or niobium-based alloys. By articles is meant any material containing niobium or niobium-based alloys that is processed to form a triniobium tin superconductor. In particular, the niobium substrate may be a foil. For purposes of this invention, a foil is defined as having a thickness about 0.0008-0.0012 inches. More specifically, the foil is about 0.001 inch thick. Herein, the invention will be described in terms of a niobium-based foil embodiment.

The term dross refers to the impurities floating on the surface of molten metals and is also called scum or scurf. Pertaining to this invention, the dross formed on the surface of the molten tin bath is triniobium tin and a combination of other niobium-tin and niobium-oxygen compounds.

One benefit of this low temperature dip system is the allowance of a simplified engineering design for the housing encasement containing the preheat furnace and the tin bath, due to the lower amount of heat radiation at processing temperatures. For instance, the seals often used in such a system are made of metal or glass. With lower tin bath temperatures, they can be fabricated from silicon rubber.

Another benefit of this invention is that the lower tin dip temperature increases the viscosity of the tin bath. This allows a slower foil speed through the bath to achieve the minimum limit imposed on the thickness of the tin layer provided by the tin dip. The increased viscosity of the tin lowers the minimum velocity of the foil. The option to operate the process at lower speeds will reduce the demands on the cooling system.

A most important benefit of the claimed process is that the lower temperature of the tin dip operation minimizes and retards the formation of triniobium tin, $Nb_3Sn$, dross. In the past triniobium tin dross formation in the tin bath has been shown to be a large problem in the manufacture of long lengths of triniobium tin foil.

The processing of triniobium tin superconducting foil requires multiple steps. The general method, using liquid tin and solid niobium diffusion, is well known. One schedule used for making the triniobium tin superconductor foil includes the following steps: cleaning the niobium foil; anodizing the foil to add specific amounts of oxygen to the surface or preheating the foil in an oxygen containing environment; tin dipping; and reaction annealing to form the triniobium tin superconductor. Of these steps, this invention relates to an improved tin dipping process, which operates from about 300-800°C and can contain up to twenty atomic percent copper in the tin bath.

Foil utilizable with this invention can be pure niobium foil or a niobium-based alloy foil, such as niobium 1 atomic percent zirconium foil (Nb-1 at.% Zr). Herein, the use of the term foil includes pure niobium and niobium alloy foils.

Prior to tin dipping, the foil can be anodized to form an oxide layer to add specific amounts of oxygen to the niobium foil surface. However, if the foil is not anodized, the surface of the foil will still have an oxidized layer due to its exposure to an ambient atmosphere containing oxygen. It is important in the practice of this invention that the oxide layer, regardless of its origin, be substantially removed from the surface of the foil immediately preceding the tin dip. This is because the presence of oxides on the surface of the niobium foil inhibits wetting of the tin to the foil. Wetting for the purpose of this invention signifies the adhesion of the liquid tin coating to the niobium foil.

With traditional 1050°C tin baths, the oxide layer on the foil is driven or diffused into the foil, which prepares the foil for tin wetting. This is sometimes referred to as a self-gettering diffusion process. The self-gettering occurs in the short hot zone above the tin bath or in the tin bath itself.

If the temperature of the tin dipping process is low, self-gettering may not occur in the hot zone above the tin bath or in the bath. As a result, wetting of the tin to the niobium foil may be inhibited. To insure against this , a short preheating step in a substantially oxygen free atmosphere is done immediately preceding the tin dip. Annealing the niobium foil for a period between about ten to about thirty seconds in a substantially oxygen free atmosphere above 900°C drives the surface oxygen into the foil. The high temperature preheat provides an environment for the foil's self-gettering of oxygen and insures wetting of the foil.

During the foil preheat, the diffusion of the surface oxygen into the niobium foil is represented by the equation:

$$Nb_2O_5 = 2Nb + 5"O",$$

where "O" is dissolved oxygen. The temperature of the preheat is determined by the temperature at which the oxygen dissolves into the niobium foil. This temperature can be obtained from a binary phase diagram for niobium and oxygen. To demonstrate this, for anodized foil containing two atomic percent oxygen, the niobium oxide dissolves at temperatures above about 930°C. This means that, for the tin to wet to the foil, a foil preheat at a temperature greater than about 930°C is necessary.

In the practice of this invention the foil surface will not re-oxidize after the preheat if it is confined for a short time in a low-oxygen environment prior to the tin dip. A low-oxygen environment means that up to twenty parts per million oxygen can be present in the atmosphere. A short time is about one minute or less .

To illustrate the effect of the preheat on foil wettability, the surfaces of samples from foil which had been dipped at low temperatures between 500-800°C without the preheat were observed. Distinct unwet areas appeared on this foil. The number and average size of unwet area was measured for short lengths, fifteen to fifty inches, of dipped foil. A percent of unwet area was computed versus the tin dip temperature. Table I demonstrates the results.

TABLE I

| % UNWET AREA ON DIPPED FOIL WITH AND WITHOUT PREHEAT | | | | |
|---|---|---|---|---|
| Example | Temp °C | % Unwet No Preheat | % Unwet Preheat (30 sec) | % Unwet Preheat (30 sec)[*] |
| 1 | 500 | 2.35 | -- | 0.53 |
| 2 | 500 | 1.42 | -- | -- |
| 3 | 600 | -- | 0.022 | -- |
| 4 | 700 | -- | 0.001 | -- |
| 5 | 700 | -- | -- | 0.22 |
| 6 | 750 | 0.13 | -- | 0.12 |
| 7 | 800 | -- | -- | 0.00 |
| 8 | 900 | 0.00 | -- | -- |

* indicates unwet measurements were taken after tin dip and subsequent reaction anneal of the foil.

The data shows that foil wetting without a preheat is complete at about 900°C. Thus, tin baths operating below 900°C require a preheat prior to tin dipping. The preheating can be achieved by means known to those skilled in the art, such as resistive or inductive furnaces.

The temperature of the tin bath is between 300-800°C. The temperature is chosen based on whether other alloy metals are present in the tin bath, such as copper. For instance, if zero copper is present, then lower temperatures, around 300°C may be utilized. When seventeen to twenty atomic percent copper is present, the bath temperature can be above 500°C. One skilled in the art will be able to use a phase diagram for tin and alloying metals in the bath to aid in the selection of the bath temperature.

It is also important to point out that this process can be applied to continuous rolls of foil traveling through the tin bath, as well as to short foil lengths that are dipped statically. The time that the foil is in the tin bath is controlled by the speed that it travels through the bath. At lower temperatures, slower speeds can be used and thicker tin deposits are obtained. The tin coating should be thick enough to form triniobium tin during the subsequent reaction anneal. Thus, the desired thickness of the tin coat governs the speed that the foil travels through the tin bath.

Operating the tin bath at low temperatures reduces significantly the rate of formation of triniobium tin dross. The temperature dependence of dross formation at low temperatures can be approximated using a triniobium tin reaction model that follows a normal kinetic path. The model is based on measuring the activation energy for the process that forms triniobium tin on niobium alloy foil. The model calculates a reaction rate in microns per second for the formation of triniobium tin at various temperatures according to the well-known Arrenhius equation:

$$rate = Ce^{-(Q/RT)}$$

where C is a constant of proportionality, Q is the activation energy, R is the gas constant, and T is the temperature. The activation energy for dross formation is proportional to that for forming triniobium tin using the above model.

When niobium alloy foil passes through the tin dip, two metallurgical processes are occurring at the foil surface. Triniobium tin is being formed and niobium is being dissolved. These two processes can be represented by the following equations:

$$\text{Formation: } Nb + Sn = Nb_3Sn, \text{ and}$$

$$\text{Dissolution: } Nb_3Sn + Sn = \text{"Nb"} + Sn$$

where "Nb" is dissolved niobium. The dissolved niobium subsequently precipitates as niobium-rich dross on the tin alloy surface. The rate of dissolution of niobium in the tin alloy controls the rate of dross formation in the tin dip.

It is to be pointed out that the reaction rate in microns per second predicted by the model is used only to give relative information about the kinetics of dross formation at different temperatures. Table II shows the reaction rate predicted by the model for different temperatures. The results show that the reaction rate at 700°C is about 400 times lower than the reaction rate at the normal operating tin bath temperature of 1050°C.

TABLE II

| REACTION RATE OF Nb$_3$Sn DROSS FORMATION VERSUS TEMPERATURE | | |
|---|---|---|
| Example | Temp °C | Reaction Rate (microns per second) |
| 1 | 1050 | 0.0409 |
| 2 | 1000 | 0.0211 |
| 3 | 900 | 0.00476 |
| 4 | 800 | 0.000812 |
| 5 | 700 | 0.0000965 |

The method of this invention is further demonstrated by the following example.

EXAMPLE:

A tin bath with seventeen atomic percent copper was heated at 700°C and 1050°C. Lengths of niobium-based alloy foil containing one atomic percent zirconium and two atomic percent oxygen were dipped into the tin bath after undergoing a thirty second preheat in an argon atmosphere at 950°C. The foil lengths were twenty to twenty-five centimeters long. Following the tin dip, the foil was reaction annealed to form the triniobium tin superconductor. Table III details the data for the tin bath temperature, the subsequent reaction anneal temperature, the foil speed, tin thickness, and the triniobium tin thickness.

TABLE III

| LOW TEMPERATURE TIN BATH EXPERIMENTS | | | | |
|---|---|---|---|---|
| Example | Tin Bath Temp (°C) | Foil Speed ft/minute | Tin Thickness (microns) | Nb$_3$Sn Thickness (microns) |
| 1 | 1050 | 20 | 9.3 | 6.6 |
| 2 | 700 | 2 | 5.1 | 5.3 |

## Claims

1. A method for coating a niobium foil with dimensions of about 0.0008-0.0012 inches thick with tin comprising the steps of:
   preheating the niobium foil in a substantially oxygen free atmosphere to form a substantially oxide-free surface that wets with tin; and then dipping the niobium foil in an atmosphere containing up to about twenty parts per million oxygen into a tin bath at a temperature between about 300-800°C for a time sufficient to coat the niobium foil with tin to subsequently form triniobium tin superconductor.

2. A method according to claim 1 wherein the niobium foil is a niobium-based alloy material.

3. A method according to claim 2 wherein the niobium-based alloy material is a foil consisting essentially of niobium, about one atomic percent zirconium and about two atomic percent oxygen.

4. A method according to claim 1 wherein the substantially oxygen free atmosphere consists essentially of an inert gas and up to twenty parts per million oxygen.

5. A method according to claim 4 where the inert gas is selected from the group consisting of argon, helium, and a mixture of argon and helium.

6. A method according to claim 1 where the preheat is above 900°C for up to about thirty seconds.

7. A method according to claim 1 where the tin bath consists essentially of tin and up to about twenty atomic percent copper.

8. A method according to claim 7 where the tin bath consists essentially of tin and about seventeen atomic percent copper.

9. A method for coating niobium-based alloy foil that is about 0.0008-0.0012 inches thick with tin to subsequently form triniobium tin superconductor comprising the steps of:

preheating niobium-based alloy foil in an enclosed chamber in an argon atmosphere containing up to twenty parts per million oxygen to form a substantially oxide-free surface that wets with tin; and then continuously passing the preheated foil through a bath containing tin with about seventeen atomic percent copper at a temperature between about 500-800°C at a speed to coat the foil with a sufficient thickness of tin to subsequently form a triniobium tin superconductor.

**European Patent Office**

**EUROPEAN SEARCH REPORT**

Application Number

EP 95 30 3434

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-3 346 467 (LLOYD R. ALLEN) * column 2; claims 1-4; figures 1-3 * | 1,2 | C23C2/08 |
| A | FR-A-1 308 466 (COMPAGNIE FRANCAISE THOMSON-HOUSTON) * page 4, column 2; example 4 * | 1 | |
| A | GB-A-1 048 904 (GENERAL ELECTRIC COMPANY) * claim 1; figure 2 * | 1,2 | |
| A | FR-A-2 078 115 (PLESSEY HANDEL UND INVESTMENTS) * page 6, line 1 - line 7; claims 1-15; figures 1,2 * | 1-3,6,7 | |
| A | GB-A-2 257 437 (GENERAL ELECTRIC COMPANY) * claims 1,2 * | 2,3 | |
| A | US-A-2 374 926 (COLIN G. FLINK) | | |
| A | US-A-2 215 278 (CARL E. SCHWARTZ) | | TECHNICAL FIELDS SEARCHED (Int.Cl.6) |
| A | US-A-3 277 557 (JOHN L. HAM) | | C23C |
| A | EP-A-0 477 029 (TOTOKU ELECTRIC) | | |

The present search report has been drawn up for all claims

| Place of search | Date of completion of the search | Examiner |
|---|---|---|
| THE HAGUE | 10 October 1995 | Elsen, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document